Europäisches Patentamt

European Patent Office

Office européen des brevets

(11) Publication number: **0 189 700**
**A2**

(12) **EUROPEAN PATENT APPLICATION**

(21) Application number: 85402569.9

(22) Date of filing: 20.12.85

(51) Int. Cl.⁴: **G 11 C 7/00**

(30) Priority: 28.12.84 US 686964

(43) Date of publication of application:
06.08.86 Bulletin 86/32

(84) Designated Contracting States:
DE FR GB IT NL

(71) Applicant: THOMSON COMPONENTS-MOSTEK
CORPORATION
1215 West Crossby Road
Carrollton Texas 75006(US)

(72) Inventor: Johnson, Mark G.
THOMSON-CSF SCPi 19, avenue de Messine
F-75008 Paris(FR)

(74) Representative: Guérin, Michel et al,
THOMSON-CSF SCPi 19, avenue de Messine
F-75008 Paris(FR)

(54) Static RAM having a flash clear function.

(57) A static RAM having a flip-flop cell employs a circuit for simultaneously clearing all cells to a logic zero, in which one of two ground lines is raised to VCC, thereby forcing one node of the flip-flop high.

*FIG. 1*

EP 0 189 700 A2

## Static RAM Having a Flash Clear Function

Technical Field

The field of the invention is that of integrated circuit static random access memories.

Background Art

Many applications of random access memory (RAM) require the contents of the entire memory array to be reset to the logical zero state. Not only in the final use, but also in the testing process, it is necessary to have a speedy reset capability. Further, it is convenient and sometimes necessary in the initialization of an electronic system when the power is first turned on to set the memory to a known state, typically all zeros.

In most static RAMs, it is necessary to step sequentially through all the memory cells and write each memory cell to a logic zero. One method known in the art (Circuit Techniques for a 25ns 16Kx1 SRAM Using Address-Transition Detection, by J. J. Barnes, et al, IEEE Journal of Solid-State Circuits Vol. SC-19, No. 4, August, 1984, page 455) is to configure the row and column decoders so that every row and every column is selected. The logic value presented at the data terminals is thus written into all the memory cells simultaneously. This bulk write cycle takes between 30 and 40 times as long as a normal write cycle. This circuit employs a standard memory cell having two supply terminals, one for VCC and one for VSS. A technique disclosed in U.S. Patent

-4002

4,439,843 performs a bulk-write in a DRAM by selecting all cells and forcing the data lines to the desired state.

A CMOS static RAM cell having two VSS (ground) lines is disclosed in: "An 18-ns CMOS/SOS 4k Static RAM", by M. Isobe et al, appearing in the IEEE Journal of Solid-State Circuits, Vol. SC-16 No. 5, October, 1981.

Summary of the Invention

The invention relates to a static RAM with a memory cell having at least one terminal in addition to the normal VCC, ground (VSS), bit lines, and word line, in which the extra terminal is connected to the memory cell so that the cell may be forced into a desired logic state.

A feature of the invention is the use of a dual purpose line for providing one of the normal functions as well as the state-forcing function.

Another feature of the invention is the use of a cell layout combining two VSS lines to each cell, one of which is a special terminal used for the flash clear operation.

Yet another feature of the invention is the use of a VSS line including the flash clear line, shared with the adjacent cells bordering on that line.

Yet another feature of the invention is the provision of an automatic clear operation on power-up.

Yet another feature of the invention is the provision of a flash write sequence by controlling the other VSS line.

Brief Description of Drawings

Figure 1 illustrates in partially pictorial, partially schematic form, a memory cell constructed according to the invention.

Figure 2 illustrates the circuit of Figure 1, redrawn to better illustrate the cell layout.

Figure 3 illustrates a memory array of the cells in Figure 1 together with a driver circuit for accomplishing the flash clear function.

Figure 4 illustrates an automatic flash clear circuit to operate on power-up.

Best Mode of Carrying Out the Invention

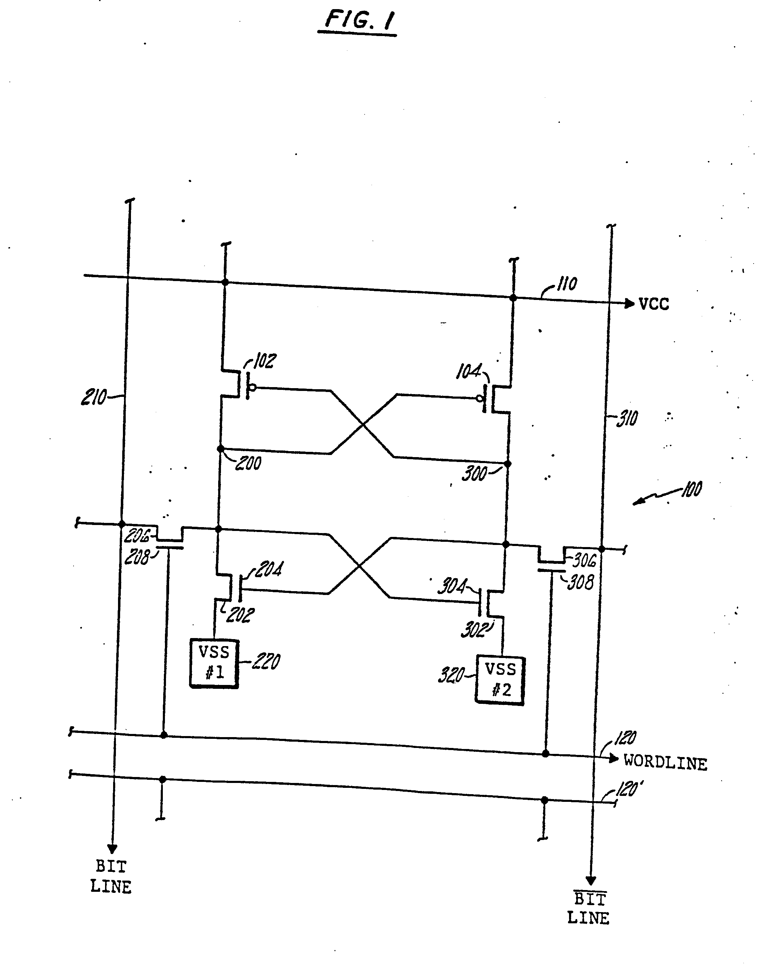

Referring now to Figure 1, there is shown a typical static RAM cell 100 constructed according to the invention. Cell 100 is bounded on the top by VCC line 110; on the bottom by word line 120; on the left by bit line 210, the "true" bit line; and on the right by bit line 310, the "complementary" bit line. This figure is in partially schematic, partially pictorial form; in that the position of the lines 110, 120, 210 and 310 are diagrammatic, but the circuit elements are shown in schematic form. The electrical configuration is for the most part a standard static RAM cell comprising a flip-flop having a data node 200 and a data-complement node 300 cross-coupled together. Node 200 is connected through P-channel pull up transistor 102 to VCC line 110. Node 200 is further connected through pass transistor 206 to bit line 210. The gate, 208, of transistor 206 is controlled by word line 120. Node 200 is connected to a current return path, or ground line 220, through data storage transistor 202 having gate 204 connected to node 300. Both transistors 202 and 206 are N-channel.

Correspondingly, the data-complement side of the flip-flop has similar circuit elements indicated by numerals having a value increased by 100.

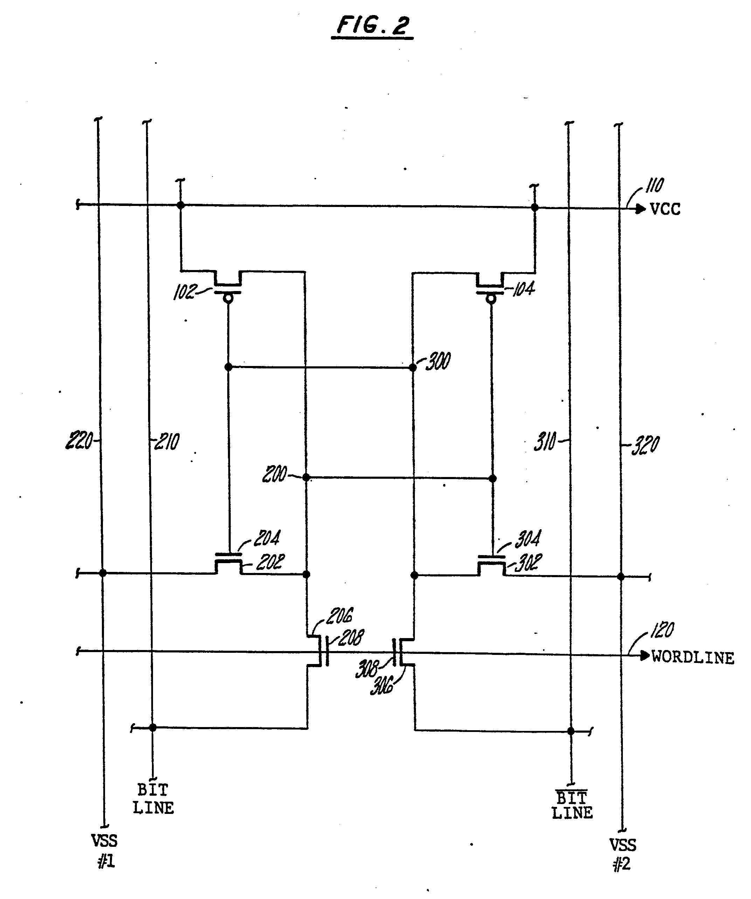

The same cell of Figure 1 is redrawn in Figure 2 in order to point out better the layout of the cell. In Figure 2, corresponding elements have corresponding reference numerals. P-channel pull-up transistors 102 and 104 are located next to VCC line 110, that is shared between the j, Kth cell shown and an adjacent cell located above line 110 in the drawing. Transistors 202, 302, 206 and 306 are located as shown, with small stubs indicating that bit lines 210 and 310 and VSS lines 220 and 320 are shared with adjacent cells. The data-complement node will alternately be on the left or right of a cell drawing because of the shared lines. For purposes of this application, the side with the VCC line will be referred to as the first side; that with lines 310 and 320 as the second side; that with word line 120 as the third side and that with lines 210 and 220 as the fourth side. The different sides will be top or bottom; left or right at different points in the cell matrix. It is not necessary that VCC run horizontally and the bit lines run vertically. These and other layout variations will be evident to those skilled in the art and the scope of the claims is not intended to be limited to the embodiment illustrated.

The word line 120 is not shared between adjacent cells because enabling the word line would read data out from two cells at the same time. Therefore, there are adjacent lines - word line 120 at the bottom of cell (j,k) and word line 120' at the top of the cell next below.

As an illustrative example, the process used is a double-level metal process in which the VSS current return lines 220 and 320 are carried on the second level, as are bit lines 210 and 310. VCC line 110 is on the first metal level and word line 120 is located both on the first metal layer and in polysilicon below the metal, thus providing a low-resistance path that is resistant to breaks in the metal.

If VSS lines 320 and 220 are connected directly to ground, this cell functions as a standard static RAM cell. Because of the use of separate VSS lines, it is possible to implement the flash clear function without the use of an additional line to the cell. In that case, VSS line 220 is connected directly to ground, but VSS line 320 is connected through a current return circuit; to be described below, that is normally a low impedance path to ground but may be controlled to rise to a positive voltage sufficiently high (typically VCC) to force flip-flop 100 into the logical zero state.

When a word line is driven high, all the cells along that row begin to sink current, so that the VSS lines are run perpendicular to the word line in order to reduce the amount of current that each VSS line must carry.

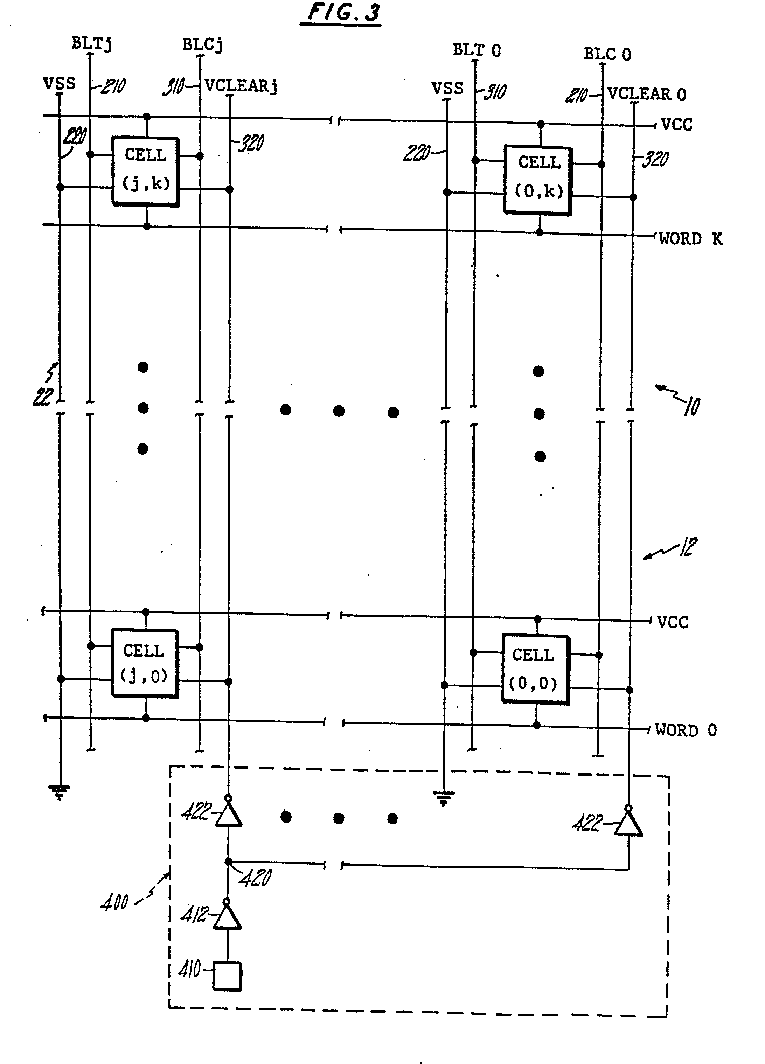

Referring now to Figure 3, a portion of a memory array containing a number of cells 100 with associated circuits lines V-clear 220, VSS 320, and bit lines 210 and 310 is shown. Note that each column, such as column 22, has a VSS line 320 connected directly to ground and a V-clear line 220 connected to inverter 422. In the normal state, inverter 422 has a low output presenting a low impedance path to ground. This is effected by control of primary inverter 412 under control of pin 410. Pin 410 is an external pin in this embodiment, though other ways to arrange for a clearing signal, such as a logic gate responding to a pattern of control signals, will be apparent to those skilled in the art.

When it is desired to clear the memory array, pin 410 is raised to a high state, forcing the clear lines 220 of the different columns to a corresponding high state that, in turn, forces all the cells 100 of the array 10 to a logical zero state. It is an advantageous feature of this invention that all the cells switch simultaneously, without drawing excessive current along any of the lines through the array and that the switching operation is done in the same time as a standard write cycle for the memory. The current capacity of inverters 422 will be selected, as is known in the art, depending on the number of cells connected to each inverter.

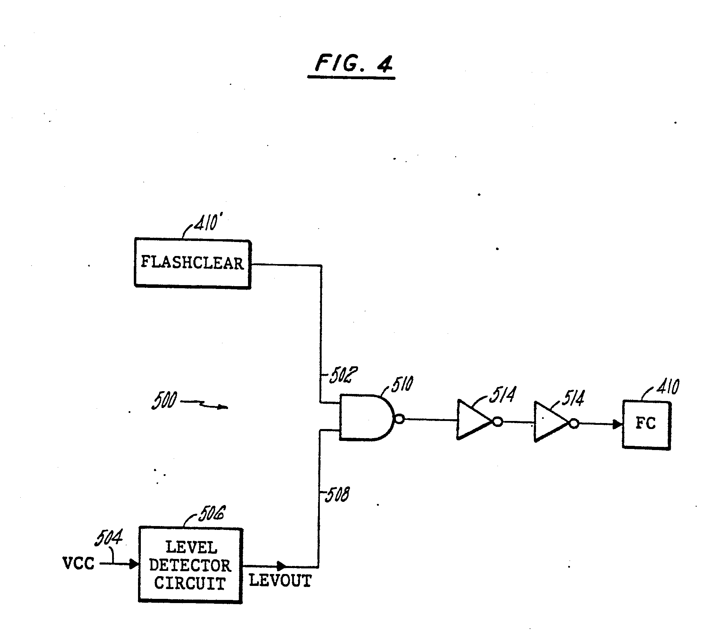

Referring now to Figure 4, there is illustrated a circuit which provides for an automatic flash clear signal when the integrated circuit first has power applied to it. In this circuit, a external control terminal 410' replaces the old control terminal 410 of Figure 3. Level detector circuit 506, a conventional circuit (such as that illustrated in "An Ultralow Power 8K x 8-Bit Full CMOS RAM with a Six-Transistor Cell", by K. Ochii et al, in IEEE Journal of Solid-State Circuits, Vol. SE-17, No. 5, October, 1982, page 798) set to produce a positive output when VCC on terminal 504 rises above some trip point voltage enters NAND gate 510 in parallel with a line from pin 410'. The output from NAND gate 510 passes through a pair of inverters 514 to terminal 410, the old input to the flash clear circuit. With this arrangement, the input to terminal 410 may come from either the external pin 410' or from the internal level detector circuit. Thus, the memory array will be reset to zero automatically every time power is turned on and it may also be reset to zero whenever a system designer wishes.

A further alternative embodiment of the invention is to apply a second driving circuit similar to circuit 400 to VSS lines 220. With this second circuit, it is possible to raise lines 220 to a positive voltage and thus to force all the memory cells in an array into a logic one state. This may be referred to as a flash-set operation. The invention may be implemented in an NMOS circuit, employing resistors or depletion transistors as the pullup devices, as is known in the art.

Those skilled in the art will readily recognize that only a portion of the memory cells may be provided with the flash clear and/or flash set
feature and also that it is possible to flash clear a
portion of the array and flash set another portion of
the array, if that is desired.

Claims

1.    An integrated circuit static RAM having an array of memory cells each of which comprises a flip-flop having first and second nodes, each of which first and second nodes is connected:

to a first power supply terminal through pull up means;

to one of a pair of bit lines through a pass transistor having a gate controlled by a word line;

to a second power supply terminal through one of a pair of data storage transistors and current return means to ground; and

to a gate of the other of said pair of data storage transistors; and

said RAM further includes reset means, connected to a selected one of said first and second nodes of at least one of said memory cells, for forcing said selected node to a predetermined voltage state, whereby said at least one of said memory cells may be set simultaneously to a logical state represented by said predetermined voltage state; characterized in that:

said reset means is connected to said selected one of said first and second nodes through a corresponding data storage transistor, and

said RAM further comprises a controllable clearing circuit for establishing a connection state to a terminal of one of said pair of data storage transistors that is either a normal state of a low - impedance path to ground or a clearing state of current path to a predetermined non-zero voltage source;

said RAM further comprises controlling means responsive to a predetermined signal for switching said controllable clearing circuit from said normal state to said clearing state, whereby all those of said array of memory cells connected to said controllable clearing circuit may be forced simultaneously into a data state determined by said predetermined non-zero voltage.

2. A RAM according to claim 1, in which said data state is that of a logical zero.

3. A RAM according to claim 1, in which said current return means comprises a pair of conductive lines extending along either side of a column of memory cells and having connections, to the source terminals of one of the data storage transistors of two adjacent columns of memory cells; and
said controlling means comprises means for raising the voltage of one of said pair of conductive lines from a normal potential close to ground to a predetermined non-zero clearing potential substantially above ground.

4. A RAM according to claim 1, in which said pullup means are P-channel MOS transistors.

5. A RAM according to claim 1, in which said pullup means are N channel depletion MOS transistors.

## FIG. 1

## FIG.2

FIG.3

0189700

3/4

0189700

## FIG. 4